# EUROPEAN PATENT SPECIFICATION

(11) **EP 2 709 141 B1**
(45) Date of publication and mention of the grant of the patent: **21.03.2018**
(21) Application number: 12786200.1
(22) Date of filing: 10.05.2012
(51) Int. Cl.: H01L 21/027

(54) **METHOD AND APPARATUS FOR FORMING A GRAPHENE PATTERN USING A DELAMINATION TECHNIQUE**
VERFAHREN UND VORRICHTUNG ZUR HERSTELLUNG EINES GRAPHENMUSTERS MITHILFE EINES DELAMINATIONSVERFAHRENS
PROCÉDÉ ET APPAREIL POUR FORMER UN MOTIF DE GRAPHÈNE À L'AIDE D'UNE TECHNIQUE DE DÉLAMINAGE

(30) Priority: 13.05.2011 KR 20110045302
(43) Date of publication of application: 19.03.2014
(73) Proprietor: Korea Research Institute of Chemical Technology, Yuseong-gu, Daejeon 305-343 (KR)
(72) Inventor: LEE, Sun Sook, Daejeon 305-343 (KR); JUNG, Daesung, Daejeon 305-343 (KR); KIM, Han Sun, Daejeon 305-343 (KR); AN, Ki-Seok, Daejeon 305-343 (KR); CHUNG, Taek-Mo, Daejeon 305-343 (KR); KIM, Chang Gyoun, Daejeon 305-343 (KR); LEE, Young Kuk, Daejeon 305-343 (KR)
(74) Representative: Samson & Partner Patentanwälte mbB
(86) International application number: PCT/KR2012/003687
(87) International publication number: WO 2012/157894

(56) References cited:
- KR-A- 20100 130 695
- KR-A- 20100 133 600
- KR-A- 20110 043 335
- US-A1- 2009 200 707
- MATTHEW J. ALLEN ET AL: "Soft Transfer Printing of Chemically Converted Graphene", ADVANCED MATERIALS, vol. 21, no. 20, 25 May 2009 (2009-05-25), pages 2098-2102, XP055319134, DE ISSN: 0935-9648, DOI: 10.1002/adma.200803000

## Description

### TECHNICAL FIELD

The present invention relates to a method for manufacturing graphenes, and more particularly, to a method and apparatus for forming a graphene pattern based on a peel-off technique that are adequate to form a graphene pattern of interest having an arbitrary pattern on a substrate through the use of a peel-off technique using a polymer stamp.

### BACKGROUND ART

As is known well, graphenes are materials having a planar single-layer structure (e.g., carbon nanostructures) in which carbon atoms are filled in two-dimensional lattices. A graphene has several unique properties, among the others, such as relatively excellent charge mobility, low surface resistance, mechanical property of matter, thermal and chemical stability, and the like relative to other materials. Therefore, in recent years, there has been reported research results related to many applications that utilize the unique physical, chemical and mechanical properties of the graphene.

In particular, the graphene is evaluated as the most suitable material for applying it to transparent electrodes of the next-generation electronic devices, TFT channels, and others owing to the characteristics such as transparency, bending property, electrical conductivity, and charge mobility.

Thus, for applying the graphene to a variety of devices, there is a need for a technique of patterning the graphene in all of the application fields such as electrodes, channel layers and the like.

Presently, the patterning of the graphene has been made by the photolithography technique mainly used in the semiconductor process, which has considerable constraints in terms of a large-area patterning, processing prices, processing times and others.

Actually, patterning the graphene should satisfy several conditions such as the fabrication of a uniform line width necessary to obtain a uniform electrical property, the formation of the desired pattern at the desired position, and the mass production of the graphene at low cost.

US 2009/200707 A1 relates to fabrication of graphene structures having a predefined pattern. A method comprises obtaining a body of highly oriented graphite and patterning at least a surface layer of the body by removing the substance of the body outside the predefined pattern. Thereafter, the method comprises stamping a graphene structure on the substrate by pressing the patterned surface layer of the body against the substrate.

In MATTHEW J. ALLEN ET AL, "Soft Transfer Printing of Chemically Converted Graphene", ADVANCED MATERIALS, DE, (20090525), vol. 21, no. 20, pages 2098 - 2102, a transfer printing process is disclosed. The transfer printing process allows precise patterning of chemically converted graphene. The use of a polydimethylsiloxane (PDMS) stamp and surface energy manipulation resulted in successfully transferring spin-coated materials from one substrate to another. The method is capable of transferring sharp features to precise locations. This represents large-scale, high-throughput transfer printing of chemically converted graphene and paves the way for future complementary circuit design.

### DISCLOSURE

### TECHNICAL PROBLEM

To do it, various techniques have been attempted to selectively remove a portion of the graphene from a substrate after the graphene is formed (grown) on the substrate, but all the techniques are merely low-technologies that may be used in laboratories.

Therefore, there exists a strong need for a way of patterning a graphene that can meet the conditions such as the uniform line width, the desired pattern and the mass production. However, there is no proposals or suggestions at all until now.

### TECHNICAL SOLUTION

The present invention is defined in the independent claims. The dependent claims define embodiments thereof

A method a method for forming a graphene pattern layer using an organic solvent by physically and selectively peeling off a portion of the graphene layer, thereby forming the graphene pattern layer on the the substrate.

A method for forming a graphene pattern layer using a peel-off technique, includes: forming a graphene layer on a substrate; forming a graphene peeling-off layer on a pattern surface of a polymer stamp, the polymer stamp having embossed patterns; aligning the pattern surface of the polymer stamp with a target position of the graphene layer to contact with each other; and separating the polymer stamp from the substrate to selectively peel off a portion of the graphene layer adhered on the respective embossed patterns of the polymer stamp from the substrate, thereby forming the graphene pattern layer.

A method for forming a graphene pattern layer using a peel-off technique, includes: preparing a rotating polymer stamp, wherein the polymer stamp has embossed patterns formed along its outer circumferential surface, a graphene peeling-off layer being applied to a surface of the respective embossed patterns; preparing a substrate on which a graphene layer is formed; and contacting the rotating stamp with the graphene layer while rotating the rotating stamp to selectively peel off a portion of the graphene layer adhered on the respective embossed patterns from the substrate, thereby forming the graphene pattern layer on the substrate.

A method for forming a graphene pattern layer using a peel-off technique, includes: preparing a rotating polymer stamp, wherein the polymer stamp has embossed patterns formed along its outer circumferential surface, a graphene peeling-off layer being applied to a surface of the respective embossed patterns; preparing a substrate on which a graphene layer is formed; contacting the rotating stamp with the graphene layer while rotating the rotating stamp to selectively peel off a portion of the graphene layer adhered on the respective embossed patterns from the substrate, thereby forming the graphene pattern layer on the substrate; removing the graphene peeling-off layer on which the portion of the graphene layer, was peeled off from the substrate, is adhered with the rotation of the rotating stamp; and applying a graphene peeling-off layer on the surface of the respective embossed patterns that are advanced in the direction of a forwarding direction of the substrate with the rotation of the rotating stamp.

An apparatus for forming a graphene pattern layer using a peel-off technique, includes: a rotating polymer stamp, wherein the rotating stamp has embossed patterns formed along its outer circumferential surface, a graphene peeling-off layer being applied to the surface of the respective embossed patterns, and wherein the rotating stamp rotates to come in contact with a graphene layer formed on a substrate to selectively peel off a portion of the graphene layer adhered on the surface of the respective embossed patterns from the substrate; a peeling-off layer removing unit configured to remove the graphene peeling-off layer on which the portion of the graphene layer, was peeled off from the substrate, is adhered with the rotation of the rotating stamp; and a peeling-off layer applying unit configured to apply a graphene peeling-off layer on the surface of the respective embossed patterns that are advanced in the direction of a forwarding direction of the substrate with the rotation of the rotating stamp.

A method for forming a graphene pattern layer using a peel-off technique, includes: preparing a large-area stamp of a polymer having embossed patterns, the surface of the respective embossed pattern having a graphene peeling-off layer applied thereto; preparing a substrate on which a graphene layer is formed; contacting the large-area stamp with the graphene layer to selectively peel off portions of the graphene layer adhered on the surfaces of the embossed patterns from the substrate, thereby forming the graphene pattern layer on the substrate; removing the graphene peeling-off layers and the graphene layers on the embossed patterns of the large-area stamp; and newly applying a graphene peeling-off layer on the surfaces of the embossed patterns of the large-area stamp.

An apparatus for forming a graphene pattern layer using a peel-off technique, includes: a large-area stamp, wherein the large-area stamp includes embossed patterns, graphene peeling-off layers being applied to the surfaces of the embossed patterns, the large-area stamp making the surfaces of the embossed patterns contact with a graphene layer formed on a substrate to selectively peel off portions of the graphene layer adhered on the surfaces of the embossed patterns from the substrate; a peeling-off removing unit configured to remove the graphene peeling-off layers of the embossed patterns on which the portions of the graphene layer, which was peeled off from the substrate, is adhered; and a peeling-off layer applying unit configured to newly apply a graphene peeling-off layer on the surfaces of the embossed patterns.

### ADVANTAGEOUS EFFECTS

In accordance with the present invention, a peel-off technique is employed to physically selectively peel off portions of a graphene layer formed on a substrate by using a polymer stamp, whereby it is possible to fabricate easily a graphene pattern in a desired shape with a uniform line width on the substrate, making use of the graphene for the fabrication of various elements.

Also, the peel-off technique is carried out in a roll-to-roll manner using a rotating stamp or in a stamping manner using a large-area stamp so as to physically selective portions of a graphene formed on a large-area substrate, whereby it is possible to fabricate easily a graphene pattern in a desired shape with a uniform line width on the large-area substrate.

### DESCRIPTION OF DRAWINGS

Figs. 1A to 1D are process flow diagrams illustrating a process of forming a graphene pattern layer on a substrate using a polymer stamp in accordance with one embodiment of the present invention;
Fig. 2 is a schematic diagram showing an example of an apparatus for forming a graphene pattern layer on a substrate using a rotating stamp in roll-to-roll manner in accordance with another embodiment of the present invention;
Fig. 3 is a schematic diagram showing an example of an apparatus for forming a graphene pattern layer on a substrate using a rotating stamp in roll-to-roll manner in accordance with further another embodiment of the present invention;
Fig. 4 is a schematic diagram showing an example of an apparatus for forming a graphene pattern layer on a substrate using a rotating stamp in accordance with still another embodiment of the present invention;
Fig. 5 is a schematic diagram showing an example of an apparatus for forming a graphene pattern layer on a substrate using a rotating stamp in roll-to-roll manner in accordance with still further another embodiment of the present invention;
Fig. 6 is a schematic diagram showing an example of an apparatus for forming a graphene pattern layer on a substrate using a large-area stamp in accordance with still further another embodiment of the present invention;
Fig. 7 is a schematic diagram illustrating a process of successively forming a graphene pattern layer on a large-area substrate using a large-area stamp; and
Fig. 8 is a graph showing the result in which the graphene that was patterned through the experiment of the present invention was analyzed using Raman spectroscopy.

### BEST MODE

In accordance with an aspect of the embodiment of the present invention, portions of a graphene layer formed on a substrate is physically selectively peeled off using a polymer stamp, thereby forming a graphene pattern layer on the substrate, which makes it possible to fabricate graphenes with a semiconductor property and to manufacture semiconductor devices utilizing the graphenes.

Also, in accordance with another aspect of the embodiment of the present invention, a rotating polymer stamp is rotated in contact with a graphene layer formed on a substrate, wherein the rotating stamp has embossed patterns formed along its outer circumferential surface, a graphene peeling-off layer being applied to the surface of the embossed patterns, to selectively peel off a portion of the graphene layer adhered on the surface of the embossed patterns from the substrate, thereby forming a graphene pattern layer on the substrate, which makes it possible to utilize in a technique for forming a graphene pattern layer having a target pattern on a large-area substrate.

Further, in accordance with another aspect of the embodiment of the present invention, a polymer stamp in which a graphene peeling-off layer is applied to the surface of the embossed patterns comes in contact with a graphene layer and then is separated (or detached) therefrom to selectively peel off a portion of the graphene layer adhered on the embossed patterns from a large-area substrate, thereby forming a graphene pattern layer on the large-area substrate.

In the embodiment, the graphene layer may be formed by a CVD method or may be formed by coating a graphene oxide on a substrate and then reducing the graphene oxide into a graphene layer. The polymer stamp or the rotating polymer stamp may be a PDMS (polydimethylsiloxane) stamp. Further, the graphene peeling-off layer may be an organic solvent such as DMSO (dimethyl sulfoxide) solvent or THF (tetrahydrofuran) solvent to which a spin-coating process can be applied.

In addition, the graphene pattern layer may be utilized as any one of a graphene resistor, a graphene wiring, a graphene channel layer, graphene charge trapping layer for memories, an on/off switch for transistors, a sensor device, a light detecting device, a heat dissipation element, a heating element.

In the following description of the embodiment of the present invention, well-known functions or constitutions will not be described in detail if they would unnecessarily obscure the embodiments of the invention. Further, the terminologies to be described below are defined in consideration of functions in the invention and may vary depending on a user's or operator's intention or practice. Accordingly, the definition may be made on a basis of the content throughout the specification.

Hereinafter, the embodiments of the present invention will be described in detail with reference to the accompanying drawings.

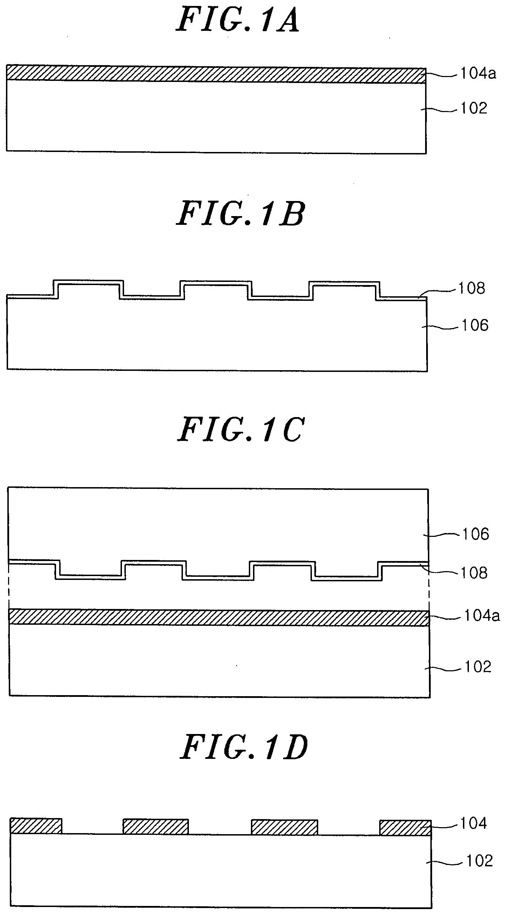

Figs. 1A to 1D are process flow diagrams illustrating a process of forming a graphene pattern layer on a substrate using a polymer stamp in accordance with one embodiment of the present invention.

Referring to Fig. 1A, a graphene layer 104a is formed on a substrate 102. For example, the graphene layer 104 may be formed on the substrate 102 through the use of a CVD (Chemical Vapor Deposition) method or may be formed by coating a graphene oxide on the substrate 102 and then reducing the graphene oxide into a graphene layer.

Next, by means of carrying out a spin coating process, for example, as shown in Fig. 1B, an organic solvent layer 108 is formed on the pattern surface of a polymer stamp 106 that has an embossed pattern. The organic solvent layer 108 used herein may be, for example, an organic solvent such as a DMSO (dimethyl sulfoxide) solvent or a THF (Tetrahydrofuran) solvent, and the polymer stamp 106 may include, for example, a PDMS stamp.

Subsequently, as shown in Fig. 1C, the polymer stamp 106 is aligned with the graphene layer 104a so that the pattern surface on which the graphene peeling-off layer 108 is formed comes in contact with the target position of the graphene layer. Such a contact state is maintained for a preset time. Thereafter, the polymer stamp 106 is separated from the substrate 102, thereby leaving the graphene pattern layer 104 on the substrate 102, as shown in Fig. 1D. In other words, the graphene pattern layer 104 of interest is formed on the substrate 102 by selectively peeling off only the graphene layer 104a attached on the embossed pattern of the polymer stamp.

In this case, it is preferred that a stamping process (or patterning process) used for forming the graphene pattern layer 104 on the substrate 102 is carried out at room temperature enough not to evaporate the organic solvent used as the graphene peeling-off layer 108.

Further, the graphene pattern layer 104 that is formed on the substrate 102 by the stamping process may be used as, for example, any one of a graphene resistor, a graphene wiring, a graphene channel layer, a graphene charge trapping layer for memories, an on/off switch of transistors, a sensor device, a light detecting device, a heat dissipation element, and so on.

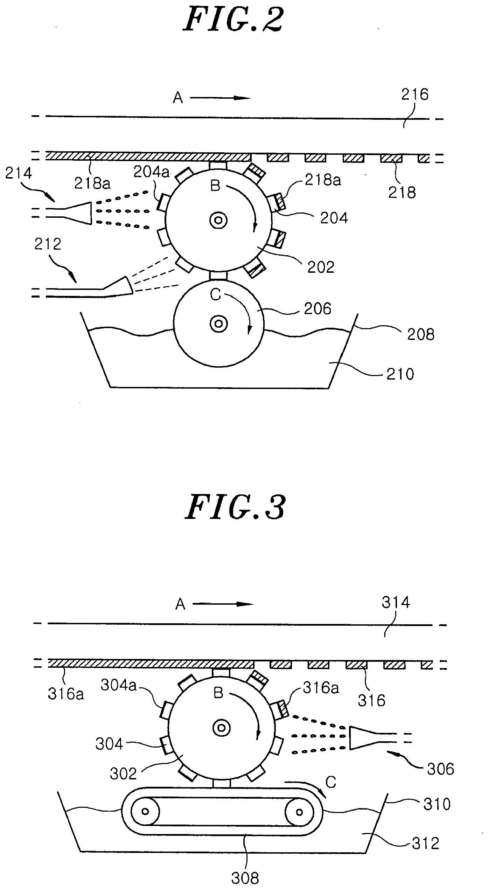

Alternatively, a graphene pattern layer of interest may be formed on a large-area substrate in a roll-to-roll manner using a rotating stamp made of polymers, instead of using the polymer stamp, which will be described in detail below with reference to the accompanying drawings of Figs. 2 to 5.

Fig. 2 is a schematic diagram showing an example of an apparatus for forming a graphene pattern layer on a substrate using a rotating stamp in a roll-to-roll manner in accordance with another embodiment of the present invention.

Referring to Fig. 2, an apparatus for forming a graphene pattern layer of the embodiment includes a rotating stamp 202 of a polymer having embossed patterns 204 that are formed along its outer circumferential surface, wherein a graphene peeling-off layer 204a will be formed (or applied) on the surfaces of the embossed patterns 204, a cleaning rotating body 206 that acts as a unit for removing the peeling-off layer when the stamping process is performed in a roll-to-roll manner, a reservoir 208 containing a cleaning fluid 210 (for example, water, etc.), a blower 212 that acts as a drying unit, and an injector 214 that serves as a unit for applying the peeling-off layers. In Fig. 2, a reference numeral 216 indicates a substrate, a reference numeral 218a indicates a graphene layer, and a reference numeral 218 indicates a graphene pattern layer. In this regard, a graphene layer 218a may be formed in the same way as the graphene layer illustrated in Fig. 1, and a graphene peeling-off layer 204a may be the same material as the graphene peeling-off layer shown in Fig. 1.

First, when a stamping progress (a patterning process using a rotating stamp) is started, the substrate 216 is advanced (entered) in the direction of an arrow A, the rotating polymer stamp 202 is rotated in the direction of an arrow B (the clockwise direction), and the cleaning rotating body 206 is rotated in the direction of an arrow C (the clockwise direction) and then stays at a target position (for example, at a location where the surface of one specific embossed pattern comes into contact with a portion of the graphene layer) for a preset time. The advancing speed of the substrate 216 may be synchronized with the rotation speed of the rotating stamp 202 and the cleaning rotating body 206.

In this process, although it is not specifically shown in the drawing, the advance (entrance) in the forward direction of the substrate 216 and the rotation of the rotating stamp 202 and the cleaning rotating body 206 may be controlled by power fed from various power sources (for example, a motor, a motor drive, a rotation axis, or the like).

In other words, the substrate 216 is advanced in the direction of an arrow A, and the rotating stamp 202 is rotated clockwise and then stops at a target position (for example, at a location where the surface of one specific embossed pattern comes into contact with a portion of the graphene layer) for a preset time when reaching the target position. In turn, after a given time has passed, when the advance of the substrate 216 is restarted along with the rotation of the rotating stamp 202, a portion of the graphene layer 218a adhered on the embossed pattern of the rotating stamp 202 is selectively peeled off from the substrate 216, thereby leaving a graphene pattern layer 218 on the substrate 216. In this case, the preset time to keep the contact state between the embossed pattern of the rotating stamp 202 and the graphene layer 218a may be set to, for example, one minute, 1 minute and 30 seconds, or 2 minutes, which may be determined in consideration of materials of the graphene peeling-off layer 204a.

After the graphene layer 218a, which was peeled off from the substrate 216, is adhered to the graphene peeling-off layer 204a, with the rotation of the rotating stamp 202, the embossed pattern having the graphene layer on the embossed pattern proceeds to the cleaning rotating body 206 where the graphene peeling-off layer 204a having the graphene layer 218a adhered thereon, which is applied on the embossed pattern 204, is completely removed (or cleaned). In other words, the cleaning rotating body 206 which is partially immersed into a cleaning fluid contained in the reservoir 210 completely removes the graphene peeling-off layer 204a and the graphene layer 218a applied and adhered on the embossed pattern 204 by cleaning the graphene peeling-off layer 204a applied on the portion of the embossed pattern of the rotating stamp 202 with the outer peripheral surface of the cleaning rotating body 206 (for example, by a method for wiping off the graphene peeling-off layer in close contact with the cleaning rotating body). Therefore, the outer peripheral surface of the cleaning rotating body 206 may be made of a material having flexibility and elasticity that is capable of absorbing the cleaning fluid to a certain extent.

The embossed pattern 204 from which the graphene peeling-off layer was removed completely by the cleaning rotating body 206 using the cleaning fluid are advanced toward the blower 212 with the rotation of the rotating stamp 202, and the blower 212 dries the surface of the embossed pattern 204, for example, by blowing the hot air.

And, the embossed pattern from which the cleaning fluid was removed completely as it passes through the blower 212 with the rotation of the rotating stamp 202 is advanced to the injector 214. The injector 214 injects a graphene peeling-off material through an injection nozzle to newly form (or apply) a graphene peeling-off layer 204a on the surface of the embossed pattern.

In other words, in accordance with the graphene forming apparatus in this embodiment, by running continuously a series of processes that are circulated in a sequence of: selectively peeling off the graphene layer → cleaning the surface of the embossed pattern (to remove the graphene peeling-off layer) → drying the surface of the embossed layer → newly applying the graphene peeling-off layer on the surface of the embossed pattern → selectively peeling off a portion of the graphene layer, through a roll-to-roll manner using a rotating stamp, it is possible to form readily the graphene pattern layer of interest on the large-area substrate.

Fig. 3 is a schematic diagram showing an example of an apparatus for forming a graphene pattern layer on a substrate using a rotating stamp in a roll-to-roll manner in accordance with further another embodiment of the present invention.

Referring to Fig. 3, an apparatus for forming a graphene pattern layer of the embodiment includes a rotating stamp 302 of a polymer having embossed patterns 304 that are formed along its outer circumferential surface, a graphene peeling-off layer 304a being formed (or applied) on the surface of the respective embossed patterns 304, a cleaning fluid injector 306 having an injection nozzle that acts as a unit for removing a peeling-off layer when a stamping process is performed in a roll-to-roll manner, a conveyer belt 308 that acts as a unit for applying a peeling-off layer, and a reservoir 310 containing a graphene peeling-off material. In Fig. 3, a reference numeral 314 indicates a substrate, a reference numeral 316a indicates a graphene layer, and a reference numeral 316 indicates a graphene pattern layer. In this regard, the graphene layer 316a may be formed in the same way as the graphene layer illustrated in Fig. 1, and a graphene peeling-off layer 304a may have the same material as the graphene peeling-off layer shown in Fig. 1.

First, when a stamping progress (a patterning process using a rotating stamp) is started, the substrate 314 is advanced (entered) in the direction of an arrow A at a preset advancing speed, the rotating polymer stamp 202 is rotated in the direction of an arrow B (the clockwise direction), and the conveyor belt 308 is rotated in the direction of an arrow C (the clockwise direction) and then stays at a target position (for example, at a location where the surface of one specific embossed pattern comes into contact with a portion of the graphene layer) for a preset time. The advancing speed of the substrate 314 may be synchronized with the rotation speed of the rotating stamp 302 and the cleaning conveyor belt 308.

In this process, although it is not specifically shown in the drawing, the advance (entrance) in the forward direction of the substrate 314 and the rotation of the rotating stamp 302 and the conveyor belt 308 may be controlled by power fed from various power sources (for example, a motor, a motor drive, a rotation axis, or the like).

In other words, the substrate 304 is advanced in the direction of an arrow A, and the rotating stamp 302 is rotated clockwise and then stops at a target position (for example, at a location where the surface of one specific embossed pattern comes into contact with a corresponding to a graphene layer) for a preset time) when reaching the target position. Then, after a given time has passed, when the advance of the substrate 314 is restarted along with the rotation of the rotating stamp 302, a portion of the graphene layer 316a adhered to the embossed pattern of the rotating stamp 302 is selectively peeled off (or chipped off) from the substrate 314, thereby forming the graphene pattern layer 316 on the substrate 314. In this case, the preset time to keep a contact state in which the embossed pattern of the rotating stamp 302 comes in contact with the graphene layer 316a may be set to, for example, one minute, 1 minute and 30 seconds, or 2 minutes, which may be determined in consideration of materials of the graphene peeling-off layer 304a.

After the graphene layer 316a, which was peeled off from the substrate 314, is adhered to the graphene peeling-off layer 304a, with the rotation of the rotating stamp 302, the embossed pattern 304 having the graphene layer on the graphene peeling-off layer arrives at the cleaning fluid injector 306, which in turn completely removes the graphene peeling-off layer 304a and the graphene layer 316a adhered on the surface the embossed pattern by injecting the cleaning fluid through an injection nozzle.

Next, the embossed pattern 304 from which the graphene peeling-off layer was removed completely through the injection of the cleaning fluid is advanced toward the conveyor belt 308 with the rotation of the rotating stamp 302, and a graphene peeling-off layer 304a is newly formed (or applied) on the surface of the embossed pattern 304 through the use of the conveyor belt 308. More specifically, the conveyor belt 308 that is partially immersed into the graphene peeling-off material 312 contained in the reservoir 310 applies newly the graphene peeling-off material to the surface of the embossed pattern 304 by keeping in contact with the surface of the embossed pattern 304 while rotating during the stamping process, thereby forming the graphene peeling-off layer 304a on the surface of the embossed pattern 304. To achieve it, the conveyor belt 306 may be made of a material having flexibility and elasticity capable of absorbing the graphene peeling-off material to a certain extent.

In other words, in accordance with the graphene forming apparatus in this embodiment, by running continuously a series of processes that is circulated in a sequence of: selectively peeling off the graphene layer → cleaning the surface of the embossed pattern (to remove the graphene peeling-off layer) → newly applying the graphene peeling-off layer on the surface of the embossed pattern → selectively peeling off a portion of the graphene layer from the embossed pattern, through a roll-to-roll manner using a rotating stamp, it is possible to form readily the graphene pattern layer of interest in the large-area substrate.

While the embodiment of the present invention has been described that the graphene peeling-off layer is newly applied on the surface of the embossed pattern using the conveyor belt after removing the graphene peeling-off layer and the portion of the graphene layer that was applied and adhered on the surface of the embossed pattern of the rotating stamp by injecting the cleaning fluid using the cleaning fluid injector, the embodiment is not limited in this regard. For example, as in the apparatus illustrated in Fig. 2, the embodiment may be designed such that a drying blower is disposed between the cleaning fluid injector and the conveyor belt and the graphene peeling-off layer is then applied on the surface of the embossed patterns after drying the surface of the embossed pattern.

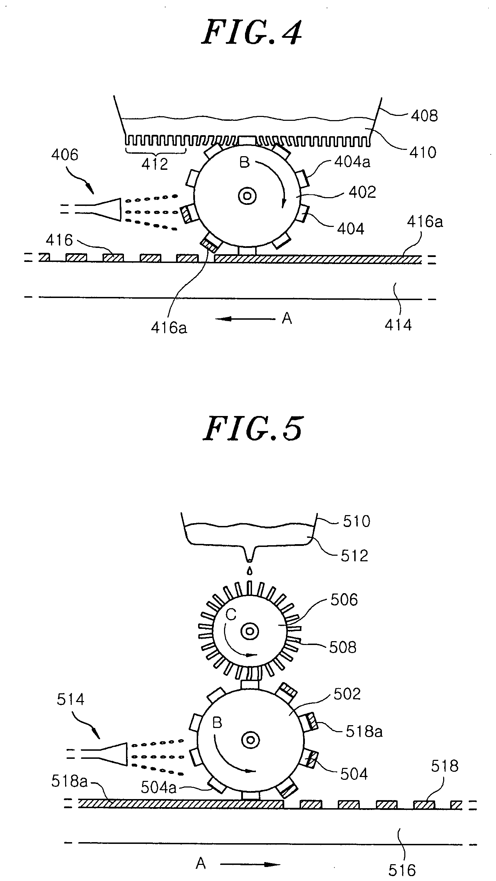

Fig. 4 is a schematic diagram showing an example of an apparatus for forming a graphene pattern layer on a substrate using a rotating stamp in accordance with still another embodiment of the present invention.

Referring to Fig. 4, an apparatus for forming a graphene pattern layer of the embodiment includes a rotating stamp 402 of a polymer having embossed patterns 404 that are formed along its outer circumferential surface, wherein a graphene peeling-off layer 404a will be formed (or applied) on the surface of the respective embossed patterns 404, a cleaning fluid injector 406 having an injection nozzle that acts as a unit for removing a peeling-off layer when a stamping process is performed in a roll-to-roll manner, an applying unit (or a coating unit with fabric brush) 408 in the form of a brush with fluid channels that functions as a coating machine. Formed on one side of the applying unit 408 (i.e., a portion where the embossed pattern of the rotating stamp passes through while closely contacting with the applying unit) is a flexible fieber bundle (or a brush) 412 that is capable of absorbing a graphene peeling-off material 410 contained in a reservoir. In Fig. 4, a reference numeral 414 indicates a substrate, a reference numeral 416a indicates a graphene layer, and a reference numeral 416 indicates a graphene pattern layer. In this regard, the graphene layer 416a may be formed in the same way as the graphene layer illustrated in Fig. 1, and the graphene peeling-off layer 404a has the same material as the graphene peeling-off layer shown in Fig. 1.

First, when a stamping progress (a patterning process using a rotating stamp) is started, the substrate 414 is advanced (entered) in the direction of an arrow A at a preset advancing speed, the rotating polymer stamp 402 is rotated in the direction of an arrow B (the clockwise direction) and then stays for a preset time at a target position (for example, at a location where the surface of one specific embossed pattern comes into contact with a portion of the graphene layer). The advancing speed of the substrate 414 may be synchronized with the rotation speed of the rotating stamp 402.

In this process, although it is not specifically shown in the drawing, the advance (entrance) in the forward direction of the substrate 414 and the rotation of the rotating stamp 402 may be controlled by power fed from various power sources (for example, a motor, a motor drive, a rotation axis, or the like).

In other words, the substrate 414 is advanced in the direction of an arrow A, and the rotating stamp 402 is rotated clockwise and then stops at a target position (for example, at a location where the surface of one specific embossed pattern comes into contact with a portion of the graphene layer) for a preset time when reaching the target position). Then, after a given time has passed, when the advance of the substrate 414 is restarted along with the rotation of the rotating stamp 402, the portion of the graphene layer 416a adhered to the embossed pattern of the rotating stamp 402 is selectively peeled (or chipped off) from the substrate 414, thereby forming the graphene pattern layer 416 on the substrate 414. In this case, the preset time to keep the contact state in which the embossed pattern of the rotating stamp 402 comes in contact with the portion of the graphene layer 416a may be set to, for example, one minute, 1 minute and 30 seconds, or 2 minutes, which may be determined in consideration of materials of the graphene peeling-off layer 404a.

After the graphene layer 416a, which was peeled off from the substrate 414, is adhered to the graphene peeling-off layer 404a, with the rotation of the rotating stamp 402, the embossed pattern 404 having the portion of the graphene layer on the graphene peeling-off layer arrives at the cleaning fluid injector 406, which in turn completely removes the graphene peeling-off layer 404a and the graphene layer 416a adhered on the embossed pattern 404 by injecting the cleaning liquid through the injection nozzle.

Next, the embossed pattern 404 from which the graphene peeling-off layer was removed completely through the injection of the cleaning fluid are directed to the flexible brush 412 of the applying unit 408 with the rotation of the rotating stamp 402, and a graphene peeling-off layer 404a is newly formed (or applied) on the surface of the embossed pattern 404 through the use of the flexible brush 412. More specifically, the flexible brush 412 that absorbs the graphene peeling-off material 410 contained in the reservoir applies the graphene peeling-off material to the surface of the embossed pattern 404 as the embossed pattern passes through while (when rotating)keeping in contact with the flexible brush , thereby forming the graphene peeling-off layer 404a newly.

In other words, in accordance with the graphene forming apparatus in this embodiment, by running continuously a series of processes that is circulated in a sequence of: selectively peeling off the graphene layer → cleaning the surface of the embossed pattern (to remove the graphene peeling-off layer) → newly applying the graphene peeling-off layer on the surface of the embossed pattern → selectively peeling off the portion of the graphene layer through a roll-to-roll manner using the rotating stamp, it is possible to form readily the graphene pattern layer of interest in a large-area substrate.

Meanwhile, while the embodiment of the present invention has been described that a graphene peeling-off layer is newly applied on the surface of the embossed pattern using the applying unit after removing the graphene peeling-off layer and the graphene layer that was coated and adhered on the surface of the embossed pattern of the rotating stamp by injecting the cleaning fluid using the cleaning fluid injector, the embodiment is not limited in this regard. For example, as in the apparatus illustrated in Fig. 2, it will be understood that a drying blower may be disposed between the cleaning fluid injector and the applying unit, and the graphene peeling-off layer may be coated repeatedly on the surface of the respective embossed patterns after drying the surface of the embossed pattern.

Fig. 5 is a schematic diagram showing an example of an apparatus for forming a graphene pattern layer on a substrate using a rotating stamp in a roll-to-roll manner in accordance with still further another embodiment of the present invention.

Referring to Fig. 5, an apparatus for forming a graphene pattern of the embodiment includes a rotating stamp 502 of a polymer having embossed patterns 504 that are formed along its outer circumferential surface, wherein a graphene peeling-off layer 504a will be formed (or applied) on the surface of the respective embossed patterns 504, a cleaning roller 506 that acts as a unit for removing the peeling-off layer when a stamping process is performed in a roll-to-roll manner and has plural filaments 508 formed on its outer circumferential surface, a reservoir 510 containing a cleaning fluid 512 (for example, water or the like), and an injector 514 that functions as an applying unit for the peeling-off layer. In Fig. 5, a reference numeral 516 indicates a substrate, a reference numeral 518a indicates a graphene layer, and a reference numeral 518 indicates a graphene pattern layers. In this regard, a graphene layer 518a may be formed in the same way as the graphene layer illustrated in Fig. 1, and a graphene peeling-off layer 504a has the same material as the graphene peeling-off layer shown in Fig. 1.

First, when a stamping progress (a patterning process using a rotating stamp) is started, the substrate 516 is advanced (entered) in the direction of an arrow A at a preset advancing speed, the rotating polymer stamp 502 is rotated in the direction of an arrow B (the clockwise direction), and the cleaning roller 506 is rotated in the direction of an arrow C (the counter clockwise) and then stays for a preset time at a target position (for example, at a location where the surface of one specific embossed pattern comes into contact with a portion of the graphene layer). The advancing speed of the substrate 516 may be synchronized with the rotation speed of the rotating stamp 502 and the cleaning roller 506.

In this process, although it is not specifically shown in the drawing, the advance (entrance) in the forward direction of the substrate 516 and the rotation of the rotating stamp 502 and the cleaning roller 506 may be controlled by power fed from various power sources (for example, a motor, a motor drive, a rotation axis, or the like).

In other words, the substrate 516 is advanced in the direction of an arrow A, and the rotating stamp 302 is rotated clockwise and then stops at a target position (for example, at a location where the surface of one specific embossed pattern comes into contact with a portion of the graphene layer) for a preset time when reaching the target position. Then, after a given time has passed, when the advance of the substrate 516 is restarted along with the rotation of the rotating stamp 502, the portion of the graphene layer 518a adhered to the embossed pattern of the rotating stamp 502 is selectively peeled off (or chipped off) from the substrate 516, thereby forming the graphene pattern layer 518 on the substrate 516. In this case, the preset time to keep the contact state in which the embossed pattern of the rotating stamp 502 comes in contact with the portion of graphene layer 518a may be set to, for example, one minute, 1 minute and 30 seconds, or 2 minutes, which may be determined in consideration of materials of the graphene peeling-off layer 504a.

After the graphene layer 518a, which was peeled off from the substrate 516, is adhered to the graphene peeling-off layer 504a, with the rotation of the rotating stamp 502, the embossed pattern having the graphene layer on the graphene peeling-off layer arrives at the cleaning roller 506. The graphene peeling-off layer 504a having the graphene layer 518a on the embossed pattern 504 are completely removed (or cleaned) by the use of the filaments 508 formed on the outer circumferential surface of the cleaning roller 506. In this embodiment, the filaments 508 may be flexible fiber filaments capable of absorbing the cleaning fluid injected from the reservoir 510.

In other words, the cleaning roller 506 removes the graphene peeling-off layer 504a and the graphene layer 518a that are coated and adhered on the embossed pattern of the rotating stamp 502 by wiping off them using the filaments 508 absorbing the cleaning fluid.

Next, the embossed pattern 504 from which the graphene peeling-off layer was removed completely through the rotation of the cleaning roller 506 is directed to the injector 514 with the rotation of the rotating stamp 502, and the injector 514 newly forms (or applies) a graphene peeling-off layer 504a on the surface of the embossed pattern 504 by injecting the graphene release material through the injection nozzle.

In other words, in accordance with the graphene forming apparatus in this embodiment, by running continuously a series of processes that are circulated in a sequence of: selectively peeling off the graphene layer → cleaning the surface of the embossed pattern (to remove the graphene peeling-off layer) → newly applying the graphene peeling-off layer on the surface of the embossed pattern → selectively peeling off the portion of the graphene layer through a roll-to-roll manner using a rotating stamp, it is, therefore, possible to form readily the graphene pattern layer of interest in a large-area substrate.

Meanwhile, while the embodiment of the present invention has been described that a graphene peeling-off layer is newly applied on the surface of the embossed pattern through the injection of the graphene peeling-off material using the injector after removing the graphene peeling-off layer and the graphene layer that was are coated and adhered on the surface of the embossed pattern of the rotating stamp using the cleaning roller having a plurality of filaments formed its outer circumferential surface, the embodiment is not limited in this regard. For example, as in the apparatus illustrated in Fig. 2, a drying blower may be disposed between the cleaning roller and the injector and the graphene peeling-off layer may be newly applied on the surface of the respective embossed patterns after drying the surface of the embossed pattern.

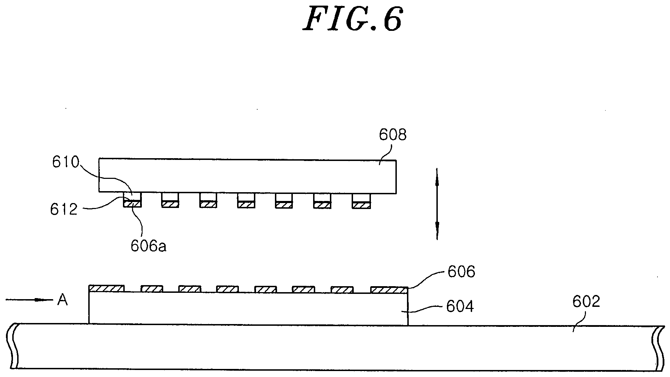

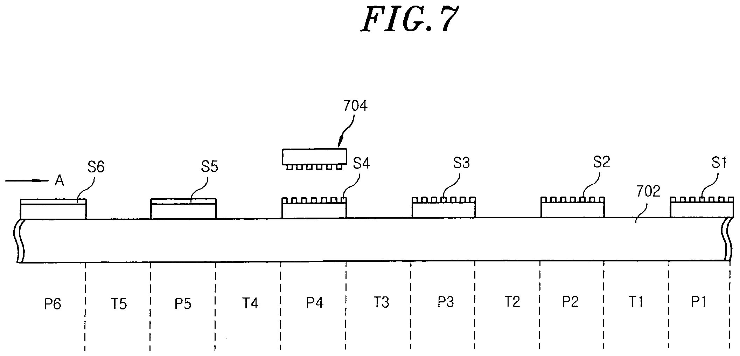

Fig. 6 is a schematic diagram showing an example of an apparatus for forming a graphene pattern layer on a substrate using a large-area stamp in a roll-to-roll manner in accordance with another embodiment of the present invention, and Fig. 7 is a schematic diagram explaining the process of successively forming a graphene pattern layer on a large-area substrate using a large-area stamp.

Referring to Fig. 6, a substrate that is intended to pattern, for example, a large-area substrate 604 having a graphene layer formed thereon is placed on a transfer unit (e.g., a conveyor belt or the like) 602 that is movable in the direction of an arrow A. The transfer unit moves in the direction of an arrow A and stops at a position to be patterned (a position facing to a large-area stamp). In this regard, the graphene layer may be formed on the large-area substrate 604 in the same way as the graphene layer illustrated in Fig. 1.

Thereafter, the large-area stamp 608 on which a graphene peeling-off layer 612 is applied on the surface of each embossed pattern moves down to the large-area substrate 604 that is aligned at its location to make the pattern surface of the large-area stamp 608 contact with the graphene layer. In this regard, the graphene peeling-off layer 612 may be formed of the same material as the graphene peeling-off layer illustrated in Fig. 1.

Subsequently, after maintaining the contact state for a preset time, the large-area stamp 608 is separated from the large-area substrate 604 by moving upward the large-area stamp 608 to selectively peel off portions of the graphene layer 606a adhered on the graphene peeling-off layers 612 of the embossed patterns 610, thereby forming the graphene pattern layer 606 of interest in the large-area substrate 604. In this case, the preset time to keep the contact state of the large-area stamp 608 may be set to, for example, one minute, 1 minute and 30 seconds, or 2 minutes, which may be determined in consideration of materials of the graphene peeling-off layer 612.

In this process, although it is not specifically shown in the drawing, the transfer of the transfer unit and the up/down movement of the large-area stamp may be controlled by power fed from various power sources (for example, a motor, a motor drive, a rotation axis, or the like).

Next, the transfer unit 602 is transferred in the direction of an arrow A so as to place the large-area substrate 604 on which the graphene pattern layer is formed away from the position where the patterning process has been done. The remainder of the graphene peeling-off layer 612 and the portions of the graphene layer 606a are removed using a cleaning unit from the surfaces of the embossed patterns, which in turn are dried through the use of a drying unit. Graphene peeling-off layers are newly applied on the surfaces of the embossed patterns 610 using an applying unit for the peeling-off layers.

In this case, the cleaning unit may be a cleaning fluid injector to inject a cleaning fluid toward the pattern surface of the large-area stamp or a moving roller having hygroscopic filaments formed along its circumferential surface. Further, the drying unit may include, for example, a blower to discharge a heating air. In addition, the applying unit for the peeling-off layers may be, for example, an injector to inject the graphene peeling-off material toward the pattern surface of the large-area stamp or a moving roller having hygroscopic filaments formed along its circumferential surface capable of absorbing and retaining a graphene peeling-off material.

Once the application of the graphene peeling-off material is completed over the embossed patterns, by repetitively performing a process of transferring the transfer unit in the direction of an arrow A to align the large-area substrate that is intended for patterning at a position to be patterned and its next processes, the graphene pattern layer may be formed on the large-area substrate.

As shown in Fig. 7, by repeatedly performing a series of processes including putting a plurality of large-area substrates S1 to S6 at intervals by a predetermined distance from each other on a conveyor belt 702, intermittently transferring the conveyor belt 702, moving up and down a large-area stamp 704, removing a graphene peeling-off layer and graphene layer on an embossed pattern, and newly applying a graphene peeling-off layer on the embossed pattern, the graphene layer may be formed on the large-area substrates that arrive at the position to be patterned in order with the transfer of the conveyor belt 702.

In Fig. 7, each of P1 to P6 sections represent an interval during which the graphene pattern layer is formed on a large-area substrate through the up and down movement of the large-area stamp 704, and each of Tl to T5 sections represent and interval during which the graphene peeling-off layer and the graphene layer are removed from the embossed patterns of the large-area stamp 704 and graphene peeling-off layers are newly applied on the embossed patterns.

In other words, in accordance with the graphene forming apparatus in this embodiment, by running continuously a series of processes that are circulated in a sequence of: transferring the conveyor belt → aligning the large-area substrate at a position to be patterned → forming the graphene.pattern layer through the down and up movements of the large-area stamp → transferring the conveyor belt → cleaning the surface of the embossed pattern (to remove the graphene peeling-off layer) → newly applying a graphene peeling layer on the embossed pattern → transferring the conveyor belt, it is possible to form readily the graphene pattern layer of interest on the large-area substrate.

On the other hand, while the embodiment of the present invention has been described that the graphene pattern layer is formed on the large-area substrate by making the transfer unit move in a horizontal direction and making the large-are stamp move up and down direction, the embodiment is merely an exemplary instance and is not limited in this regard. For example, it will be understood that the system may be configured in the form of making the transfer unit and the large-area stamp upright to face with each other and making the large-area stamp move from side to side, thereby forming the graphene pattern layer on the large-area substrate. In this case, convenience may be improved when removing the graphene peeling-off layers and the portions of the graphene layers on the embossed patterns of the large-area stamp and newly applying a graphene peeling-off layer.

### [Experimental Example]

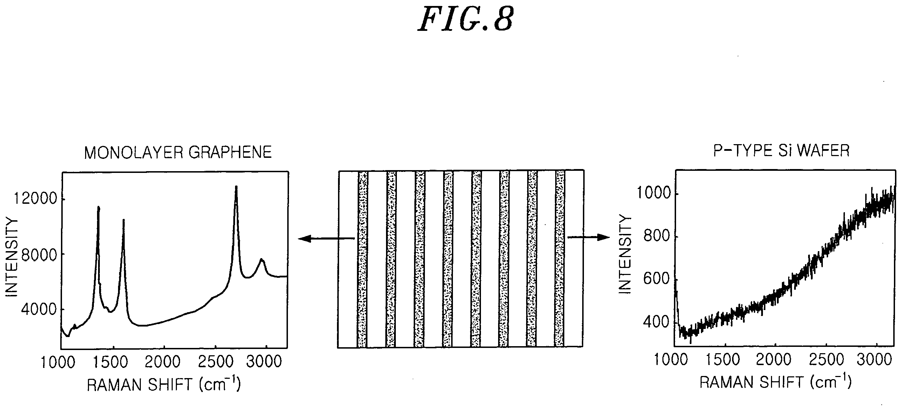

The inventors of the present invention carried out an experiment of spin-coating an organic solvent on a pattern surface of a polymer stamp twice for 20 seconds at 2,000 rpm at room temperature and stamping the polymer stamp on the graphene formed on P-type silicon wafer for a stamping retention time of one minute. The experimental result is shown in Fig. 8.

Fig. 8 is a graph showing the result in which the graphene that was patterned through the experiment of the present invention was analyzed using Raman spectroscopy.

Referring to Fig. 8, the inventors clearly found that graphene-related Raman peaks were observed in a pattern portion from the graph acquired through the experiment, but were not observed in areas on which the graphene was patterned.

In the description as set forth above, while the present invention has been explained with reference to preferred embodiments, the present invention is not limited thereto, and it will be understood by those skilled in the art that various substitutions, changes and modifications may be made without departing from the scope of the embodiments of the present invention.

## Claims

1. A method for forming a graphene pattern layer using a peel-off technique, the method comprising:
forming a graphene layer (104a, 218a, 316a, 416a, 518a, 606a) on a substrate (102, 216, 314, 414, 516, 604);
aligning surfaces of embossed patterns (204, 304, 404, 504, 610) included in a polymer stamp (106, 202, 402, 502) with a target position of the graphene layer (104a, 218a, 316a, 416a, 518a, 606a) to contact with each other; and
separating the polymer stamp (106, 202, 402, 502) from the substrate (102, 216, 314, 414, 516, 604) to selectively peel off a portion of the graphene layer (104a, 218a, 316a, 416a, 518a, 606a) adhered on the embossed patterns (204, 304, 404, 504, 610) from the substrate (102, 216, 314, 414, 516, 604), thereby patterning the graphene layer (104a, 218a, 316a, 416a, 518a, 606a),
the method being **characterized in** further comprising:
forming a graphene peeling-off layer (108, 204a, 304a, 404a, 504a, 612) on the surfaces of the embossed patterns (204, 304, 404, 504, 610) before said aligning.

2. The method of claim 1, wherein the graphene layer (104a, 218a, 316a, 416a, 518a, 606a) is formed by a CVD method, and is also formed by coating a graphene oxide on the substrate (102, 216, 314, 414, 516, 604) and reducing the graphene oxide into the graphene layer (104a, 218a, 316a, 416a, 518a, 606a).

3. The method of claim 1, wherein the polymer stamp (106, 202, 402, 502) is a PDMS (polydimethylsiloxane) stamp.

4. The method of claim 1, wherein the graphene peeling-off layer (108, 204a, 304a, 404a, 504a, 612) is formed by a spin-coating process and includes an organic solvent, and
wherein the organic solvent includes DMSO (dimethyl sulfoxide) solvent or THF (tetrahydrofuran) solvent.

5. The method of claim 1, wherein the polymer stamp (106, 202, 402, 502) is a rotating polymer stamp (202, 402, 502), and the embossed patterns (204, 304, 404, 504, 610) are formed along an outer circumferential surface of the rotating polymer stamp (202, 402, 502),
the method further comprising contacting the rotating polymer stamp (202, 402, 502) with the graphene layer (104a, 218a, 316a, 416a, 518a, 606a) by rotating the rotating polymer stamp (202, 402, 502) to selectively peel off the portion of the graphene layer (104a, 218a, 316a, 416a, 518a, 606a) adhered on the embossed patterns (204, 304, 404, 504, 610) from the substrate (102, 216, 314, 414, 516, 604), thereby patterning the graphene layer (104a, 218a, 316a, 416a, 518a, 606a) on the substrate.

6. The method of claim 5, wherein said patterning the graphene layer (104a, 218a, 316a, 416a, 518a, 606a) comprises:
rotating the rotating polymer stamp (202, 402, 502) to contact a specific embossed pattern among the embossed patterns (204, 304, 404, 504, 610) with the graphene layer (104a, 218a, 316a, 416a, 518a, 606a);
maintaining a contact between the specific embossed pattern and the graphene layer for a preset time; and
after the preset time has passed, rotating the rotating polymer stamp (202, 402, 502) to selectively peel off a portion of the graphene layer (104a, 218a, 316a, 416a, 518a, 606a) contacted with the specific embossed pattern.

7. The method of claim 5, further comprising:
removing the graphene peeling-off layer (108, 204a, 304a, 404a, 504a, 612) from a surface of the specific embossed pattern;
drying the surface of the specific embossed pattern after the graphene peeling-off layer (108, 204a, 304a, 404a, 504a, 612) has been removed from the specific embossed pattern; and
applying another graphene peeling-off layer on the dried surface of the specific embossed pattern to make the another graphene peeling-off layer contact with the graphene layer (104a, 218a, 316a, 416a, 518a, 606a) on the substrate (102, 216, 314, 414, 516, 604) due to a rotation of the rotating polymer stamp (202, 402, 502).

8. The method of claim 1, further comprising:
removing the graphene peeling-off layer (108, 204a, 304a, 404a, 504a, 612) and the graphene layer (104a, 218a, 316a, 416a, 518a, 606a) from the surfaces of the embossed patterns (204, 304, 404, 504, 610); and
applying another graphene peeling-off layer on the surfaces of the embossed patterns (204, 304, 404, 504, 610).

9. The method of claim 8, further comprising:
drying the surfaces of the embossed patterns (204, 304, 404, 504, 610) between said removing and said applying.

10. An apparatus for forming a graphene pattern layer using a peel-off technique according to claim 1, the apparatus comprising:
a polymer stamp (106, 202, 402, 502) including embossed patterns (204, 304, 404, 504, 610), wherein the polymer stamp (106, 202, 402, 502) makes surfaces of the embossed patterns (204, 304, 404, 504, 610) contact with a graphene layer (104a, 218a, 316a, 416a, 518a, 606a) formed on a substrate (102, 216, 314, 414, 516, 604) to selectively peel off a portion of the graphene layer (104a, 218a, 316a, 416a, 518a, 606a) adhered on the surfaces of the embossed patterns (204, 304, 404, 504, 610) from the substrate (102, 216, 314, 414, 516, 604),
the apparatus being **characterized in that**:
a graphene peeling-off layer (108, 204a, 304a, 404a, 504a, 612) is applied on the surfaces of the embossed patterns (204, 304, 404, 504, 610), and
the apparatus further comprises:
a peeling-off layer removing unit configured to remove from the surfaces of the embossed patterns (204, 304, 404, 504, 610) the graphene peeling-off layer (108, 204a, 304a, 404a, 504a, 612) and the portion of the graphene layer (104a, 218a, 316a, 416a, 518a, 606a) peeled off from the substrate (102, 216, 314, 414, 516, 604); and
a peeling-off layer applying unit configured to apply another graphene peeling-off layer (108, 204a, 304a, 404a, 504a, 612) on the surfaces of the embossed patterns (204, 304, 404, 504, 610).

11. The apparatus of claim 10, wherein the polymer stamp (106, 202, 402, 502) is a rotating polymer stamp (202, 402, 502) and embossed patterns (204, 304, 404, 504, 610) are formed along an outer circumferential surface of the rotating polymer stamp (202, 402, 502),
wherein the rotating polymer stamp (202, 402, 502) rotates to come in contact with the graphene layer (104a, 218a, 316a, 416a, 518a, 606a) formed on the substrate (102, 216, 314, 414, 516, 604) to selectively peel off the portion of the graphene layer (104a, 218a, 316a, 416a, 518a, 606a) adhered on the surface of the embossed patterns (204, 304, 404, 504, 610) from the substrate (102, 216, 314, 414, 516, 604), and
wherein the peeling-off layer applying unit is further configured to apply another graphene peeling-off layer (108, 204a, 304a, 404a, 504a, 612) on the surfaces of the embossed patterns (204, 304, 404, 504, 610) before the another graphene peeling-off layer contacts with the graphene layer (104a, 218a, 316a, 416a, 518a, 606a) on the substrate (102, 216, 314, 414, 516, 604) due to a rotation of the rotating polymer stamp (202, 402, 502).

12. The apparatus of claim 11, wherein the peeling-off layer removing unit comprises
a cleaning roller (506) that is configured to rotate in close contact with the surfaces of the embossed patterns (204, 304, 404, 504, 610) in the same rotation direction as the rotating polymer stamp (202, 402, 502) to remove the graphene peeling-off layer (108, 204a, 304a, 404a, 504a, 612) formed on the surfaces of the embossed patterns (204, 304, 404, 504, 610) and the portion of the graphene layer (104a, 218a, 316a, 416a, 518a, 606a) adhered on the graphene peeling-off layer (108, 204a, 304a, 404a, 504a, 612) with a cleaning fluid (210, 512) fed from a reservoir (208, 510); and
a cleaning fluid injector (306, 406) that is configured to remove the graphene peeling-off layer (108, 204a, 304a, 404a, 504a, 612) formed on the surfaces of the embossed patterns (204, 304, 404, 504, 610) and the portion of the graphene layer (104a, 218a, 316a, 416a, 518a, 606a) adhered on the graphene peeling-off layer (108, 204a, 304a, 404a, 504a, 612) by injecting a cleaning fluid using an injection nozzle.

13. The apparatus of claim 11, wherein the peeling-off layer applying unit comprises
an injector (214, 514) that is configured to apply a graphene peeling-off layer (108, 204a, 304a, 404a, 504a, 612) on the surfaces of the embossed patterns (204, 304, 404, 504, 610) by injecting a graphene peeling-off material (312, 410);
a conveyor belt (308) that is configured to rotate in close contact with the surfaces of the embossed patterns (204, 304, 404, 504, 610) in the same rotation direction as the rotating polymer stamp (202, 402, 502) to apply the another graphene peeling-off layer on the surfaces of the embossed patterns (204, 304, 404, 504, 610) with a graphene peeling-off material (312, 410) provided from a reservoir (310); and
an applying unit (408) that is configured to provide a graphene peeling-off material (312, 410) provided from a reservoir (310) and adhered on a filament bundle (412, 508) to the surfaces of the embossed patterns (204, 304, 404, 504, 610) when the rotating polymer stamp (202, 402, 502) rotates, thereby forming the graphene peeling-off layer (108, 204a, 304a, 404a, 504a, 612).

14. The apparatus of claim 10, further comprising:
a drying unit configured to dry the surfaces of the embossed patterns (204, 304, 404, 504, 610) from which the graphene peeling-off layer (108, 204a, 304a, 404a, 504a, 612) has been removed to make the another graphene peeling-off layer is applied on the surfaces of the embossed patterns (204, 304, 404, 504, 610).

## Patentansprüche

1. Verfahren zum Bilden einer Graphenstrukturschicht unter Verwendung einer Abziehtechnik, wobei das Verfahren umfasst:
Bilden einer Graphenschicht (104a, 218a, 316a, 416a, 518a, 606a) auf einem Substrat (102, 216, 314, 414, 516, 604);
Ausrichten von Oberflächen erhabener Strukturen (204, 304, 404, 504, 610), welche in einem Polymerstempel (106, 202, 402, 502) enthalten sind, mit einer Zielposition der Graphenschicht (104a, 218a, 316a, 416a, 518a, 606a) derart, dass sie in Kontakt miteinander gebracht werden; und
Trennen des Polymerstempels (106, 202, 402, 502) von dem Substrat (102, 216, 314, 414, 516, 604) derart, dass ein Teil der Graphenschicht (104a, 218a, 316a, 416a, 518a, 606a), welcher an den erhabenen Strukturen (204, 304, 404, 504, 610) anhaftet, selektiv von dem Substrat (102, 216, 314, 414, 516, 604) abgezogen wird, wodurch die Graphenschicht (104a, 218a, 316a, 416a, 518a, 606a) strukturiert wird.
wobei das Verfahren **gekennzeichnet ist durch**:
Bilden einer Graphenabziehschicht (108, 204a, 304a, 404a, 504a, 612) auf den Oberflächen der erhabenen Strukturen (204, 304, 404, 504, 610) vor dem Ausrichten.

2. Verfahren nach Anspruch 1, wobei die Graphenschicht (104a, 218a, 316a, 416a, 518a, 606a) durch ein CVD-Verfahren gebildet wird und auch durch Beschichten eines Graphenoxids auf dem Substrat (102, 216, 314, 414, 516, 604) und Reduzieren des Graphenoxids in die Graphenschicht (104a, 218a, 316a, 416a, 518a, 606a) gebildet wird.

3. Verfahren nach Anspruch 1, wobei der Polymerstempel (106, 202, 402, 502) ein PDMS (Polydimethylsiloxan) -Stempel ist.

4. Verfahren nach Anspruch 1, wobei die Graphenabziehschicht (108, 204a, 304a, 404a, 504a, 612) durch einen Rotationsbeschichtungsprozess gebildet wird und ein organisches Lösungsmittel enthält, und
wobei das organische Lösungsmittel DMSO (Dimethylsulfoxid) -Lösungsmittel oder THF (Tetrahydrofuran) -Lösungsmittel umfasst.

5. Verfahren nach Anspruch 1, wobei der Polymerstempel (106, 202, 402, 502) ein rotierender Polymerstempel (202, 402, 502) ist und die erhabenen Strukturen (204, 304, 404, 504, 610) entlang einer äußeren Umfangsfläche des rotierenden Polymerstempels (202, 402, 502) gebildet sind,
wobei das Verfahren ferner umfasst das Inkontaktbringen des rotierenden Polymerstempels (202, 402, 502) mit der Graphenschicht (104a, 218a, 316a, 416a, 518a, 606a) durch Rotieren des rotierenden Polymerstempels (202, 402, 502) derart, dass der Teil der Graphenschicht (104a, 218a, 316a, 416a, 518a, 606a), welcher an den erhabenen Strukturen (204, 304, 404, 504, 610) anhaftet, selektiv von dem Substrat (102, 216, 314, 414, 516, 604) abgezogen wird, wodurch die Graphenschicht (104a, 218a, 316a, 416a, 518a, 606a) auf dem Substrat strukturiert wird.

6. Verfahren nach Anspruch 5, wobei das Strukturieren der Graphenschicht (104a, 218a, 316a, 416a, 518a, 606a) umfasst:
Rotieren des rotierenden Polymerstempels (202, 402, 502) derart, dass eine bestimmte, erhabene Struktur von den erhabenen Strukturen (204, 304, 404, 504, 610) mit der Graphenschicht (104a, 218a, 316a, 416a, 518a, 606a) in Kontakt gebracht wird;
Beibehalten eines Kontakts zwischen der bestimmten, erhabenen Struktur und der Graphenschicht für eine voreingestellte Zeit; und
nachdem die voreingestellte Zeit verstrichen ist, Rotieren des rotierenden Polymerstempels (202, 402, 502) derart, dass ein Teil der Graphenschicht (104a, 218a, 316a, 416a, 518a, 606a), welcher in Kontakt mit der bestimmten, erhabenen Struktur gebracht wurde, abgezogen wird.

7. Verfahren nach Anspruch 5, ferner umfassend:
Entfernen der Graphenabziehschicht (108, 204a, 304a, 404a, 504a, 612) von einer Oberfläche der bestimmten, erhabenen Struktur;
Trocknen der Oberfläche der bestimmten, erhabenen Struktur, nachdem die Graphenabziehschicht (108, 204a, 304a, 404a, 504a, 612) von der bestimmten, erhabenen Struktur entfernt wurde; und
Aufbringen einer weiteren Graphenabziehschicht auf die getrocknete Oberfläche der bestimmten, erhabenen Struktur derart, dass die weitere Graphenabziehschicht aufgrund einer Rotation des rotierenden Polymerstempels (202, 402, 502) in Kontakt mit der Graphenschicht (104a, 218a, 316a, 416a, 518a, 606a) auf dem Substrat (102, 216, 314, 414, 516, 604) gebracht wird.

8. Verfahren nach Anspruch 1, ferner umfassend:
Entfernen der Graphenabziehschicht (108, 204a, 304a, 404a, 504a, 612) und der Graphenschicht (104a, 218a, 316a, 416a, 518a, 606a) von den Oberflächen der erhabenen Strukturen (204, 304, 404, 504, 610); und
Aufbringen einer weiteren Graphenabziehschicht auf den Oberflächen der erhabenen Strukturen (204, 304, 404, 504, 610).

9. Verfahren nach Anspruch 8, ferner umfassend:
Trocknen der Oberflächen der erhabenen Strukturen (204, 304, 404, 504, 610) zwischen dem Entfernen und dem Aufbringen.

10. Vorrichtung zum Bilden einer Graphenstrukturschicht unter Verwendung einer Abziehtechnik nach Anspruch 1, wobei die Vorrichtung umfasst:
einen Polymerstempel (106, 202, 402, 502) mit erhabenen Strukturen (204, 304, 404, 504, 610), wobei der Polymerstempel (106, 202, 402, 502) Oberflächen der erhabenen Strukturen (204, 304, 404, 504, 610) in Kontakt mit einer auf einem Substrat (102, 216, 314, 414, 516, 604) gebildeten Graphenschicht (104a, 218a, 316a, 416a, 518a, 606a) derart bringt, dass ein Teil der Graphenschicht (104a, 218a, 316a, 416a, 518a, 606a), welcher an den Oberflächen der erhabenen Strukturen (204, 304, 404, 504, 610) anhaftet, selektiv von dem Substrat (102, 216, 314, 414, 516, 604) abgezogen wird,
wobei die Vorrichtung **dadurch gekennzeichnet ist, dass**:
eine Graphenabziehschicht (108, 204a, 304a, 404a, 504a, 612) auf den Oberflächen der erhabenen Strukturen (204, 304, 404, 504, 610) aufgebracht ist, und
die Vorrichtung ferner umfasst:
eine Abziehschicht-Entfernungseinheit, welche dazu eingerichtet ist, die Graphenabziehschicht (108, 204a, 304a, 404a, 504a, 612) und den Teil der Graphenschicht (104a, 218a, 316a, 416a, 518a, 606a), welcher von dem Substrat (102, 216, 314, 414, 516, 604) abgezogen ist, von den Oberflächen der erhabenen Strukturen (204, 304, 404, 504, 610) zu entfernen; und
eine Abziehschicht-Aufbringeinheit, welche dazu eingerichtet ist, eine weitere Graphenabziehschicht (108, 204a, 304a, 404a, 504a, 612) auf den Oberflächen der erhabenen Strukturen (204, 304, 404, 504, 610) aufzubringen.

11. Vorrichtung nach Anspruch 10, wobei der Polymerstempel (106, 202, 402, 502) ein rotierender Polymerstempel (202, 402, 502) ist und erhabene Strukturen (204, 304, 404, 504, 610) entlang einer äußeren Umfangsfläche des rotierenden Polymerstempels (202, 402, 502) gebildet sind,
wobei der rotierende Polymerstempel (202, 402, 502) so rotiert, dass er in Kontakt mit der auf dem Substrat (102, 216, 314, 414, 516, 604) gebildeten Graphenschicht (104a, 218a, 316a, 416a, 518a, 606a) derart gelangt, dass der Teil der Graphenschicht (104a, 218a, 316a, 416a, 518a, 606a), welcher an der Oberfläche der erhabenen Strukturen (204, 304, 404, 504, 610) anhaftet, selektiv von dem Substrat (102, 216, 314, 414, 516, 604) abgezogen wird, und
wobei die Abziehschicht-Aufbringeinheit ferner dazu eingerichtet ist, eine weitere Graphenabziehschicht (108, 204a, 304a, 404a, 504a, 612) auf den Oberflächen der erhabenen Strukturen (204, 304, 404, 504, 610) aufzubringen, bevor die weitere Graphenabziehschicht aufgrund einer Drehung des rotierenden Polymerstempels (202, 402, 502) in Kontakt mit der Graphenschicht (104a, 218a, 316a, 416a, 518a, 606a) auf dem Substrat (102, 216, 314, 414, 516, 604) gelangt.

12. Vorrichtung nach Anspruch 11, wobei die Abziehschicht-Entfernungseinheit umfasst
eine Reinigungswalze (506), welche dazu eingerichtet ist, in engem Kontakt mit den Oberflächen der erhabenen Strukturen (204, 304, 404, 504, 610) in dieselbe Rotationsrichtung wie der rotierende Polymerstempel (202, 402, 502) so zu rotieren, dass die Graphenabziehschicht (108, 204a, 304a, 404a, 504a, 612), welche auf den Oberflächen der erhabenen Strukturen (204, 304, 404, 504, 610) aufgebracht ist, und der Teil der Graphenschicht (104a, 218a, 316a, 416a, 518a, 606a), welcher an der Graphenabziehschicht (108, 204a, 304a, 404a, 504a, 612) anhaftet, mit einem von einem Reservoir (208, 510) zugeführten Reinigungsfluid (210, 512) entfernt wird; und
einen Reinigungsfluid-Injektor (306, 406), welcher dazu eingerichtet ist, die Graphenabziehschicht (108, 204a, 304a, 404a, 504a, 612), die auf den Oberflächen der erhabenen Strukturen (204, 304, 404, 504, 610) gebildet ist, und den Teil der Graphenschicht (104a, 218a, 316a, 416a, 518a, 606a), die an der Graphenabziehschicht (108, 204a, 304a, 404a, 504a, 612) anhaftet, durch Injizieren eines Reinigungsfluids unter Verwendung einer Injektionsdüse zu entfernen.

13. Vorrichtung nach Anspruch 11, wobei die Abziehschicht-Aufbringeinheit umfasst
einen Injektor (214, 514), welcher dazu eingerichtet ist, eine Graphenabziehschicht (108, 204a, 304a, 404a, 504a, 612) auf den Oberflächen der erhabenen Strukturen (204, 304, 404, 504, 610) durch Injizieren eines Graphenabziehmaterials (312, 410) aufzubringen;
ein Förderband (308), welches dazu eingerichtet ist, in engem Kontakt mit den Oberflächen der erhabenen Strukturen (204, 304, 404, 504, 610) in derselben Rotationsrichtung wie der rotierende Polymerstempel (202, 402, 502) so zu rotieren, dass die weitere Graphenabziehschicht auf den Oberflächen der erhabenen Strukturen (204, 304, 404, 504, 610) mit einem von einem Reservoir (310) bereitgestellten Graphenabziehmaterial (312, 410) aufgetragen wird; und
eine Auftragungseinheit (408), welche dazu eingerichtet ist, ein Graphenabziehmaterial (312, 410), das von einem Reservoir (310) bereitgestellt wird und an einem Faserbündel (412, 508) anhaftet, an die Oberflächen der erhabenen Strukturen (204, 304, 404, 504, 610) bereitzustellen, wenn der rotierende Polymerstempel (202, 402, 502) rotiert, wodurch die Graphenabziehschicht (108, 204a, 304a, 404a, 504a, 612) gebildet wird.

14. Vorrichtung nach Anspruch 10, ferner umfassend:
eine Trocknungseinheit, welche dazu eingerichtet ist, die Oberflächen der erhabenen Strukturen (204, 304, 404, 504, 610), von denen die Graphenabziehschicht (108, 204a, 304a, 404a, 504a, 612) entfernt wurde, zu trocknen, um die weitere Graphenabziehschicht auf den Oberflächen der erhabenen Strukturen (204, 304, 404, 504, 610) aufzubringen.

## Revendications

1. Procédé pour former une couche de motif de graphène en utilisant une technique de décollement, le procédé comprenant les étapes suivantes :
former une couche de graphène (104a, 218a, 316a, 416a, 518a, 606a) sur un substrat (102, 216, 314, 414, 516, 604) ;
aligner des surfaces de motifs gaufrés (204, 304, 404, 504, 610) inclus dans un poinçon polymère (106, 202, 402, 502) avec une position cible de la couche de graphène (104a, 218a, 316a, 416a, 518a, 606a) pour venir en contact entre elles ; et
séparer le poinçon polymère (106, 202, 402, 502) du substrat (102, 216, 314, 414, 516, 604) pour décoller sélectivement une partie de la couche de graphène (104a, 218a, 316a, 416a, 518a, 606a) fixée sur les motifs gaufrés (204, 304, 404, 504, 610) du substrat (102, 216, 314, 414, 516, 604), formant ainsi le motif de la couche de graphène (104a, 218a, 316a, 416a, 518a, 606a),
le procédé étant **caractérisé en ce qu'**il comprend en outre l'étape suivante :
former une couche de décollement de graphène (108, 204a, 304a, 404a, 504a, 612) sur les surfaces des motifs gaufrés (204, 304, 404, 504, 610) avant ledit alignement.

2. Procédé selon la revendication 1, dans lequel la couche de graphène (104a, 218a, 316a, 416a, 518a, 606a) est formée par un procédé CVD, et est également formée en appliquant un oxyde de graphène sur le substrat (102, 216, 314, 414, 516, 604) et en réduisant l'oxyde de graphène dans la couche de graphène (104a, 218a, 316a, 416a, 518a, 606a).

3. Procédé selon la revendication 1, dans lequel le poinçon polymère (106, 202, 402, 502) est un poinçon de PDMS (polydiméthylsiloxane).

4. Procédé selon la revendication 1, dans lequel la couche de décollement de graphène (108, 204a, 304a, 404a, 504a, 612) est formée par un processus de dépôt centrifuge et comprend un solvant organique, et
dans lequel le solvant organique comprend le solvant à base de diméthyl sulfoxide (DMSO) ou un solvant à base de tétrahydrofuranne.

5. Procédé selon la revendication 1, dans lequel le poinçon polymère (106, 202, 402, 502) est un poinçon polymère rotatif (202, 402, 502) et les motifs gaufrés (204, 304, 404, 504, 610) sont formés le long d'une surface circonférentielle externe du poinçon polymère rotatif (202, 402, 502),
le procédé comprenant en outre l'étape suivante : mettre en contact le poinçon polymère rotatif (202, 402, 502) avec la couche de graphène (104a, 218a, 316a, 416a, 518a, 606a) en faisant tourner le poinçon polymère rotatif (202, 402, 502) pour décoller sélectivement la partie de la couche de graphène (104a, 218a, 316a, 416a, 518a, 606a) fixée sur les motifs gaufrés (204, 304, 404, 504, 610) du substrat (102, 216, 314, 414, 516, 604), formant ainsi le motif de la couche de graphène (104a, 218a, 316a, 416a, 518a, 606a) sur le substrat.

6. Procédé selon la revendication 5, dans lequel ladite formation de motif de la couche de graphène (104a, 218a, 316a, 416a, 518a, 606a) comprend les étapes suivantes :
faire tourner le poinçon polymère rotatif (202, 402, 502) pour faire entrer en contact un motif gaufré spécifique parmi les motifs gaufrés (204, 304, 404, 504, 610) avec la couche de graphène (104a, 218a, 316a, 416a, 518a, 606a) ;
maintenir un contact entre le motif gaufré spécifique et la couche de graphène à un moment prédéterminé ; et
après que le temps prédéterminé s'est écoulé, faire tourner le poinçon polymère rotatif (202, 402, 502) pour décoller sélectivement une partie de la couche de graphène (104a, 218a, 316a, 416a, 518a, 606a) en contact avec le motif gaufré spécifique.

7. Procédé selon la revendication 5, comprenant en outre les étapes suivantes :
retirer la couche de décollement de graphène (108, 204a, 304a, 404a, 504a, 612) d'une surface du motif gaufré spécifique ;
faire sécher la surface du motif gaufré spécifique après que la couche de décollement de graphène (108, 204a, 304a, 404a, 504a, 612) a été retirée du motif gaufré spécifique ; et
appliquer une autre couche de décollement de graphène sur la surface séchée du motif gaufré spécifique pour que l'autre couche de décollement de graphène soit en contact avec la couche de graphène (104a, 218a, 316a, 416a, 518a, 606a) sur le substrat (102, 216, 314, 414, 516, 604) en raison d'une rotation du poinçon polymère rotatif (202, 402, 502).

8. Procédé selon la revendication 1, comprenant en outre les étapes suivantes :
retirer la couche de décollement de graphène (108, 204a, 304a, 404a, 504a, 612) et la couche de graphène (104a, 218a, 316a, 416a, 518a, 606a) des surfaces des motifs gaufrés (204, 304, 404, 504, 610) ; et
appliquer une autre couche de décollement de graphène sur les surfaces des motifs gaufrés (204, 304, 404, 504, 610).

9. Procédé selon la revendication 8, comprenant en outre l'étape suivante :
sécher les surfaces des motifs gaufrés (204, 304, 404, 504, 610) entre lesdites étapes de retrait et d'application.

10. Appareil pour former une couche de motif de graphène en utilisant une technique de décollement selon la revendication 1, l'appareil comprenant :
un poinçon polymère (106, 202, 402, 502) comprenant des motifs gaufrés (204, 304, 404, 504, 610), dans lequel le poinçon polymère (106, 202, 402, 502) permet aux surfaces des motifs gaufrés (204, 304, 404, 504, 610) d'être en contact avec une couche de graphène (104a, 218a, 316a, 416a, 518a, 606a) formée sur un substrat (102, 216, 314, 414, 516, 604) pour décoller sélectivement une partie de la couche de graphène (104a, 218a, 316a, 416a, 518a, 606a) fixée sur les surfaces des motifs gaufrés (204, 304, 404, 504, 610) du substrat (102, 216, 314, 414, 516, 604),
l'appareil étant **caractérisé en ce que** :
une couche de décollement de graphène (108, 204a, 304a, 404a, 504a, 612) est appliquée sur les surfaces des motifs gaufrés (204, 304, 404, 504, 610), et
l'appareil comprend en outre :
une unité de retrait de couche de décollement configurée pour retirer des surfaces des motifs gaufrés (204, 304, 404, 504, 610), la couche de décollement de graphène (108, 204a, 304a, 404a, 504a, 612) et la partie de la couche de graphène (104a, 218a, 316a, 416a, 518a, 606a) pelée du substrat (102, 216, 314, 414, 516, 604) ; et
une unité d'application de couche de décollement configurée pour appliquer une autre couche de décollement de graphène (108, 204a, 304a, 404a, 504a, 612) sur les surfaces des motifs gaufrés (204, 304, 404, 504, 610).

11. Appareil selon la revendication 10, dans lequel le poinçon polymère (106, 202, 402, 502) est un poinçon polymère rotatif (202, 402, 502) et les motifs gaufrés (204, 304, 404, 504, 610) sont formés le long d'une surface circonférentielle externe du poinçon polymère rotatif (202, 402, 502),
dans lequel le poinçon polymère rotatif (202, 402, 502) tourne pour venir en contact avec la couche de graphène (104a, 218a, 316a, 416a, 518a, 606a) formée sur le substrat (102, 216, 314, 414, 516, 604) pour décoller sélectivement la partie de la couche de graphène (104a, 218a, 316a, 416a, 518a, 606a) fixée sur la surface des motifs gaufrés (204, 304, 404, 504, 610) du substrat (102, 216, 314, 414, 516, 604), et
dans lequel l'unité d'application de couche de décollement est en outre configurée pour appliquer une autre couche de décollement de graphène (108, 204a, 304a, 404a, 504a, 612) sur les surfaces des motifs gaufrés (204, 304, 404, 504, 610) avant que l'autre couche de décollement de graphène ne soit en contact avec la couche de graphène (104a, 218a, 316a, 416a, 518a, 606a) sur le substrat (102, 216, 314, 414, 516, 604) en raison d'une rotation du poinçon polymère rotatif (202, 402, 502).

12. Appareil selon la revendication 11, dans lequel l'unité de retrait de couche de décollement comprend :
un rouleau de nettoyage (506) qui est configuré pour tourner en contact immédiat avec les surfaces des motifs gaufrés (204, 304, 404, 504, 610) dans le même sens de rotation que le poinçon polymère rotatif (202, 402, 502) pour retirer la couche de décollement de graphène (108, 204a, 304a, 404a, 504a, 612) formée sur les surfaces des motifs gaufrés (204, 304, 404, 504, 610) et une partie de la couche de graphène (104a, 218a, 316a, 416a, 518a, 606a) fixée sur la couche de décollement de graphène (108, 204a, 304a, 404a, 504a, 612) avec un fluide de nettoyage (210, 512) alimenté à partir d'un réservoir (208, 510) ; et
un injecteur de fluide de nettoyage (306, 406) qui est configuré pour retirer la couche de décollement de graphène (108, 204a, 304a, 404a, 504a, 612) formée sur les surfaces des motifs gaufrés (204, 304, 404, 504, 610) et la partie de la couche de graphène (104a, 218a, 316a, 416a, 518a, 606a) fixée sur la couche de décollement de graphène (108, 204a, 304a, 404a, 504a, 612) en injectant un fluide de nettoyage à l'aide d'une buse d'injection.

13. Appareil selon la revendication 11, dans lequel l'unité d'application de couche de décollement comprend :
un injecteur (214, 514) qui est configuré pour appliquer une couche de décollement de graphène (108, 204a, 304a, 404a, 504a, 612) sur les surfaces de motifs gaufrés (204, 304, 404, 504, 610) en injectant un matériau de décollement de graphène (312, 410) ;
une courroie transporteuse (308) qui est configurée pour tourner en contact immédiat avec les surfaces des motifs gaufrés (204, 304, 404, 504, 610) dans le même sens de rotation que le poinçon polymère rotatif (202, 402, 502) pour appliquer l'autre couche de décollement de graphène sur les surfaces des motifs gaufrés (204, 304, 404, 504, 610) avec un matériau de décollement de graphène (312, 410) fourni à partir d'un réservoir (310) ; et
une unité d'application (408) qui est configurée pour fournir un matériau de décollement de graphène (312, 410) fourni à partir d'un réservoir (310) et fixé sur un groupe de filaments (412, 508) jusqu'aux surfaces des motifs gaufrés (204, 304, 404, 504, 610) lorsque le poinçon polymère rotatif (202, 402, 502) tourne, formant ainsi la couche de décollement de graphène (108, 204a, 304a, 404a, 504a, 612).

14. Appareil selon la revendication 10, comprenant en outre :
une unité de séchage configurée pour sécher les surfaces des motifs gaufrés (204, 304, 404, 504, 610) desquelles la couche de décollement de graphène (108, 204a, 304a, 404a, 504a, 612) a été retirée pour que l'autre couche de décollement de graphène soit appliquée sur les surfaces des motifs gaufrés (204, 304, 404, 504, 610).
